# EUROPEAN PATENT SPECIFICATION

(11) **EP 2 180 081 B1**
(45) Date of publication and mention of the grant of the patent: **11.05.2011**
(21) Application number: 08167116.6
(22) Date of filing: 21.10.2008
(51) Int. Cl.: C23C 18/12

(54) **Post-treatment composition for increasing corrosion resistance of metal or metal alloy surfaces**
Nachbehandlungszusammensetzung zur Steigerung des Rostschutzes von Metall oder Metalllegierungsflächen
Compositions post-traitement pour augmenter la résistance de corrosion de métaux ou de surfaces d'alliage métallique

(43) Date of publication of application: 28.04.2010
(73) Proprietor: ATOTECH Deutschland GmbH, 10553 Berlin (DE)
(72) Inventor: Barthelmes, Jürgen, 10317 Berlin (DE); Rüther, Robert, 16515 Oranienburg OT Lehnitz (DE); Kurtz, Olaf, 10627 Berlin (DE); Danker, Michael, 13587 Berlin (DE); Lagorce-Broc, Florence, 13467 Berlin (DE)
(74) Representative: Wonnemann, Jörg

(56) References cited:
- WO-A-96/12050
- WO-A-2006/136262
- US-A- 5 292 549

## Description

### Field of the Disclosure

The present invention relates to aqueous post-treatment compositions and an immersion process using said aqueous post-treatment compositions for corrosion protection of metal and metal alloy surfaces. The post-treatment compositions comprise at least one polysiloxane betaine compound and at least one phosphorus containing compound.

### Background of the Invention

Gold plating is often used in the electronics industry to provide a corrosion-resistant electrically conductive layer on copper base layers, typically in electrical connectors and printed circuit boards. Without using a barrier metal the copper atoms tend to diffuse through the gold layer thereby causing tarnishing of its surface and formation of an oxide and/or sulfide layer. An intermediate layer of one or more suitable barrier metals or metal alloys like nickel, nickel phosphorous alloy, nickel boron alloy, nickel palladium alloy or palladium is preferably deposited onto the copper substrate before the gold plating to prevent such undesired diffusion. The interlayer of e.g., nickel and nickel phosphorous alloy additionally provides mechanical backing for the gold layer and improves its wear resistance. It also reduces the corrosion caused by pores present in the gold layer.

Such metal and metal alloy layers are usually deposited by electroplating or electroless plating.

Any defect in the gold layer or intermediate nickel, nickel phosphorous alloy, nickel boron alloy, nickel palladium alloy or palladium layer will result in exposure of said intermediate layer or even the base material, which comprises usually copper or copper alloys. These plating defects include pores, scratches and incomplete surface coverage.

Corrosion in and around the contact interface between a connector and the connected part reduces the contact area and causes an increase in contact resistance.

Due to the demand to decrease the plating thickness, especially for all precious metal or metal alloy layers, the potential for all these defects is increased.

Therefore, a post-treatment composition is required, which provides corrosion protection for said types of substrates without altering, i.e., increasing the contact resistance of said substrates in a way that an insufficient electrical contract is obtained. Furthermore, a post-treatment composition should provide sufficient corrosion resistance also to substrates which exhibit surface areas of different metals or metal alloys, e.g., a substrate possessing both gold and tin surfaces. Another important task is to preserve the solderability of the metal surfaces after contact with a post-treatment composition.

Various methods to increase corrosion protection of metal surfaces are described in the literature.

A post-plating passivation treatment for inhibiting corrosion of precious metal plated objects is provided by the use of thin dichromate films which coat the precious metal outer surface and fill the precious metal outer surface pores using either immersion or electrolytic methods employing passivation plating techniques (US patent 5,182,172). The dichromate passivation is an electrolytically and not a dipping process and consists of free chromium VI which has a huge impact on waste water treatment and environmental protection issues.

Another gold plating process comprising an electrochemical passivation is described in US patent 4,090,934. Disclosed is a method for producing protective layers on base metals like copper in which the protective layer is made largely of gold and the surface is treated with an anodic electrolytic procedure. It is particularly useful for base or surface metals such as nickel. The anodic passivation procedure is carried out in any alkaline aqueous solution between 50°C and 75 °C. This procedure passivates the noble metal but can not effectively fill the pores of the layer and therefore is not able to avoid effectively the corrosion of the intermediate layer or the base material layer. In addition, this kind of passivation will attack tin surfaces on connector parts.

Thin siloxane films providing temporary corrosion protection to zinc or zinc alloy coated steel sheets are disclosed in US 5,292,549. Here, a mixture comprising a silane and a cross linking agent is deposited onto the substrate followed by a curing procedure at a temperature below 200 °C in order to obtain the siloxane film.

The US Patent 4,341,842 discloses a room temperature vulcanizable silicone rubber composition comprising a silanol end-stopped polysiloxane polymer, an alkyl silicate and a metal salt of a carboxylic acid. Such compositions protect (metallic) automotive parts from corrosion.

The laid open patent application WO 96/12050 A1 discloses a method providing an ultra-thin silicon-oxide layer on a metal substrate by depositing a solution of a Polyorganosiloxane onto a metal substrate followed by an UV-ozone treatment. Said method requires expensive equipment for UV-ozone treatment and is a batch-wise process which is not applicable to high-throughout surface treatment required by the connector industry. Furthermore, such ultra-thin silicon-dioxide films are not suited to block pores in thin gold layers which are the main reason for undesired corrosion of a nickel layer beneath such a thin porous gold layer.

Compositions comprising cinnamaldehyde or a derivative thereof and urea for inhibiting corrosion of metals are disclosed in WO 2006/136262 A1. Such compositions may optionally contain a betaine-type surfactant. Said compositions provide corrosion protection for metals subjected to hydrocarbons and acid-based liquids. The compositions are added to the corrosive acid-based liquids only and are not deposited as a permanent coating onto the metal surfaces.

Often, the substrate to be corrosion protected comprises surface areas of different metals, e.g., copper, copper alloy, tin, tin alloy, nickel, nickel alloy, palladium, palladium alloy, gold, gold alloy, silver, silver alloy, chromium, chromium alloy surface areas. A post-treatment composition which provides sufficient corrosion resistance to all areas at the same time would be of both economic and ecologic interest.

Thus, there is a need to provide a protection of metal and metal alloy layers which provides corrosion resistance, retaining electrical conductivity and solderability. Aqueous post-treatment compositions for said purpose should not contain hazardous or environmentally problematic compounds.

### Summary of the Disclosure

The present invention relates to aqueous post-treatment compositions and an immersion and/or electrolytical process using said compositions for corrosion protection of metal and/or metal alloy surfaces. The aqueous post-treatment compositions comprise at least one polysiloxane betaine compound and at least one phosphorus containing compound.

### Detailed Description of the Invention

The invention is directed to a method for enhancing corrosion resistance of metal or metal alloy surfaces, preferably of a gold or gold alloy surface of a workpiece. For purposes of illustration, one such workpiece is an electronic component such as an electronic lead frame, a passive component, a bump on a wafer or an electrical connector.

The invention is applicable to any metal surface, preferably a gold or gold alloy surface, whether part of an electronic device, engineering, functional, decorative, or otherwise. With regard to gold-based surfaces for electronic devices, the method enhances corrosion resistance. The invention is also applicable to a nickel, nickel phosphorus alloy, nickel boron alloy, nickel palladium alloy, ternary nickel alloy, palladium, tin, tin alloy, copper, copper alloy, silver, silver alloy, chromium or chromium alloy layer and enhances corrosion resistance of said surface compositions. Furthermore, the invention is applicable to "pre-plated lead frames" (PPF's), which exhibit a nickel layer on a lead frame made of copper or copper alloy and a very thin palladium layer on top of the nickel layer and a very thin layer of gold on said palladium layer. Very thin means here a thickness of e.g., 15 nm.

In accordance with the invention, the metal-based surface is immersed or otherwise contacted with an aqueous post-treatment composition comprising at least one polysiloxane betaine compound according to formula I. and at least one phosphorous compound according to formulas II. to VII. to form a protecting film over the metal-based surface. "Thin" is defined here as preferably not altering the contact resistance of the final good more than 30 % compared to an as-prepared final good without any post-treatment.

In one embodiment of the present invention, the film derived from the aqueous post-treatment compositions inhibit corrosion of the gold-based surface, and the underlying intermediate layers comprising one or more of nickel, nickel phosphorus alloy, nickel boron alloy, nickel palladium alloy, ternary nickel alloy and palladium.

In still another embodiment of the present invention, the films derived from the aqueous post-treatment compositions inhibit corrosion of the substrate material comprising one or more of copper and copper alloy.

The aqueous post-treatment compositions for treating a metal surface according to the present invention comprise at least one polysiloxane betaine compound represented by formula I: 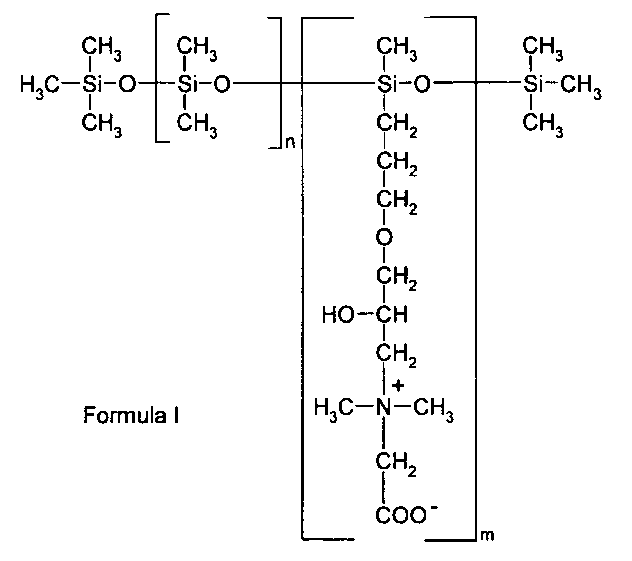 wherein n for compounds according to formula I ranges from 0 to about 200, preferred from 2 to about 100 and most preferred from 5 to about 50 and m ranges from 1 to about 50, preferred from 1 to about 25 and most preferred from 2 to about 10.

Polysiloxane betaine compounds represented by formula I. are disclosed in US 4,654,161 which is included herein by reference. An application disclosed in the '161 patent is their use as additives in hair cosmetic formulations.

The at least one polysiloxane betaine compound represented by formula I. of the aqueous solutions is preferably used in an amount of 0.05 to 50 g/l, more preferably 0.5 to 20 g/l and most preferably 1 to 10 g/l.

The aqueous post-treatment compositions further comprise at least one phosphorous compound or its salt represented by the formulas II. to VII.: 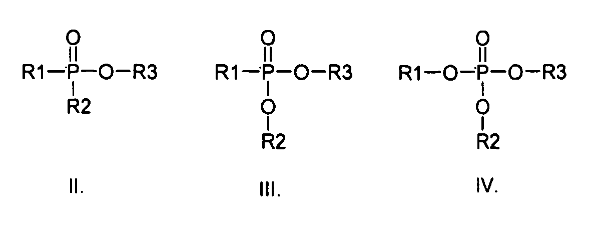 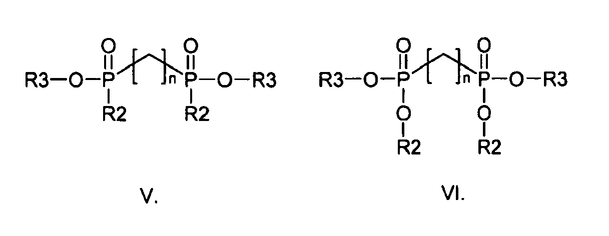 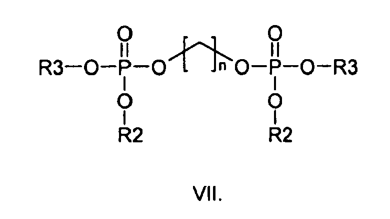 wherein R1, R2 and R3 can be equal or different and are selected independently from the group consisting of H or NH₄⁺, Li⁺, Na⁺, K⁺ or C₁-C₂₀-alkyl, substituted or unsubstituted, linear or branched, C₁-C₆-alkaryl, linear or branched, substituted or unsubstituted and aryl, substituted or unsubstituted and wherein n is an integral number ranging from 1 to 15.

Preferably, R1, R2 and R3 C₁-C₂₀ alkyl is selected independently from the group consisting of methyl, ethyl, n-propyl, isopropyl, n-hexyl, isohexyl, n-heptyl, isoheptyl, n-octly, isooctyl, n-nonyl, isononyl, n-decyl, isodecyl, n-undecyl, isodecyl, n-dodecyl, isododecyl.

In another embodiment of the present invention, R1 of the phosphorous compounds II. - VII. is selected from the group consisting of n-propyl, isopropyl, n-hexyl, isohexyl, n-heptyl, isoheptyl, n-octyl, isooctyl, n-nonyl, isononyl, n-decyl, isodecyl, n-undecyl, isodecyl, n-dodecyl, isododecyl and R2 and R3 are H.

The at least one phosphorus compound represented by the formulas II. to VII. is preferably used in an amount of 0.02 to 10 g/l, more preferably 1 to 8 g/l and most preferably 2 to 6 g/l.

The pH value of the aqueous post-treatment composition is between 2 and 10.

The corrosion resistance of a substrate is enhanced by immersing said substrate in said aqueous post-treatment composition. The immersion time is 1 s to 10 min, more preferably between 5 s and 60 s. The temperature of the aqueous post-treatment composition during immersion is between 15 °C and 70 °C, more preferably 20 °C and 60 °C. The substrate immersion is carried out preferably by a dipping process, but other processes known by the person skilled in the art are also possible.

In another embodiment of the present invention, the post-treatment is done by an electrolytical treatment of a substrate in the aqueous post-treatment composition, where the substrate is used as the cathode or anode. The applied current density is in the range of 0.1 to 2.0 A/dm².

Optionally, the post-treatment compositions may additionally contain an antifoaming agent which is commercially available.

The aqueous post-treatment composition according to the present invention is for example applied after a process as follows:
1. deposition of a nickel layer onto the substrate
2. optionally deposition of a nickel-phosphorus layer onto the nickel layer
3. deposition of a gold or a gold-based alloy layer onto the nickel or nickel-phosphorus layer.

Prior to immersion into the aqueous post-treatment composition of the present invention, said substrate might be rinsed with water.

Preferably, the substrate is then immersed into the inventive aqueous post-treatment composition.

The substrate may then optionally be rinsed with water to remove any excess of the aqueous post-treatment composition.

The present invention is further illustrated by the following examples.

### Preparation of Samples

The metal coatings described in all examples were prepared as shown in Table 1 in accordance with the process sequence provided on p. 10 of the present application.

Before plating, the substrates were degreased (ultra-sonic degreasing, and cathodic degreasing). Following the plating of the nickel layer, the surface was activated using 10 wt.-% sulphuric acid and then the gold layer was plated. Between every step the samples were rinsed with city water.

The corrosion resistance of the surfaces untreated or treated with post-treatment compositions were tested in a nitric acid vapour atmosphere followed by examination of the specimens with an optical light microscope. The standard test for porosity in gold coatings on metal substrates employing nitric acid vapour (NAV) at low relative humidity (ASTM B 735-06) was used. In this test the reaction of the gas mixture with a corrodible base metal at pore sites produces reaction products that appear as discreet spots on the gold surface. This test method is intended to be used for quantitative description of porosity and corrosion resistance (i.e., total corroded area given in mm²).

The test parameters used were as follows:

| | |
|---|---|
| HNO₃: | 69 wt.-% |
| Exposure time: | 120 min (ASTM B 735-06: 60 min) |
| Relative humidity: | max. 55 % |
| Temperature: | 20 °C |

As a substrate the base material CuSn6, sample size 0.3 x 25 x 100 mm was selected. The substrates were coated with subsequent layers of nickel (1.5 µm) and gold (0.3 µm) by a process sequence described in Table 1.

**Table 1: Process sequence used for examples 1 to 4, example 1 (comparative) is without step 3.**

| Step | Temperature | Components |
|---|---|---|
| 1 | 55 °C | Nickelsulphamate HS* (nickel) |
| 2 | 42 °C | Aurocor SC* (gold) |
| 3 | 35 °C | Treatment with post-dip composition |

| | | |
|---|---|---|
| *Commercial products of Atotech Deutschland GmbH | | |

1. Nickel-electrolyte (Nickelsulphamate HS; product of Atotech Deutschland GmbH)

| | |
|---|---|
| Make-up: | 120 g/l Ni²⁺, 8 g/l chloride, no further additive |
| Temperature: | 55 °C |
| Current density: | 10 A/dm² |
| pH: | 3.5 |
| Nickel layer thickness | 1.5 µm |

2. Gold-electrolyte (Aurocor SC, Au alloyed with Co; product of Atotech Deutschland GmbH)

| | |
|---|---|
| Make-up: | 6 g/l Au⁺ |
| Temperature: | 42 °C |
| Current density: | 11 A/dm² |
| pH: | 4 |
| Gold alloy layer thickness | 0.3 µm |

The nickel and gold coated substrates were transferred to the corrosion test without any post-treatment (Example 1, comparative example) or immersed in different aqueous post-treatment compositions prior to the corrosion test (Examples 2-4).

The substrates were finally dried and subjected to the corrosion resistance test according to ASTM B 735-06.

The corrosion damage was detected after a nitric acid vapour test (ASTM B 735-06) using an optical microscope. The values of "total corroded area" are a measure for the corrosion resistance of the test specimen, i.e., a high value for total corroded area means a low corrosion resistance and vice versa.

### Example 1 (comparative experiment)

No treatment with a post-treatment composition was applied to a CuSn6 substrate coated with a layer sequence of nickel and gold. The total corroded area of 0.28 mm² was observed after NAV test.

### Example 2 (comparative experiment)

A treatment with an aqueous post-treatment composition comprising 4.0 g/l 1-octylphosphonic acid was applied to a CuSn6 substrate coated with a layer sequence of nickel and gold. A total corroded area of 0.044 mm² was observed after NAV test.

### Example 3 (comparative experiment)

A treatment with an aqueous post-treatment composition comprising 9.0 g/l of a polysiloxane betaine compound according to formula I (TEGO SURACT B30P, TIB Chemicals) was applied to a CuSn6 substrate coated with a layer sequence of nickel and gold. A total corroded area of 0.016 mm² was observed after NAV test.

### Example 4

A treatment with an aqueous post-treatment composition comprising 4.5 g/l of a polysiloxane betaine compound according to formula I (TEGO SURACT B30P, TIB Chemicals) and 4.0 g/l 1-octylphosphonic acid was applied to a CuSn6 substrate coated with a layer sequence of nickel and gold. A total corroded area of 0.004 mm² was observed after NAV test.

The values of total corroded area measured for all examples are summarized in table 2.

**Table 2: Total corroded area for all examples.**

| Example No. | Total corroded area [mm²] |
|---|---|
| 1 (without any post-treatment) | 0.28 |
| 2 (comparative example) | 0.044 |
| 3 (comparative example) | 0.016 |
| 4 (invention) | 0.004 |

The example of the present invention shows the best value for total corroded area and therefore the best corrosion protection.

## Claims

1. An aqueous post-treatment composition for treating a metal or metal alloy surface comprising
at least one polysiloxane betaine compound represented by formula I: 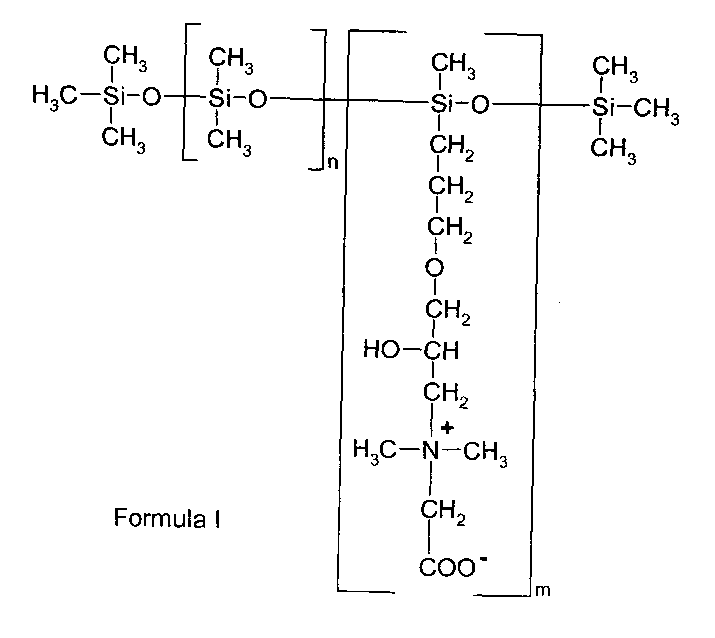 wherein n for compounds according to formula I ranges from 0 to 200 and m ranges from 1 to 50 and at least one phosphorous compound or its salt represented by the formulas II. to VII.: 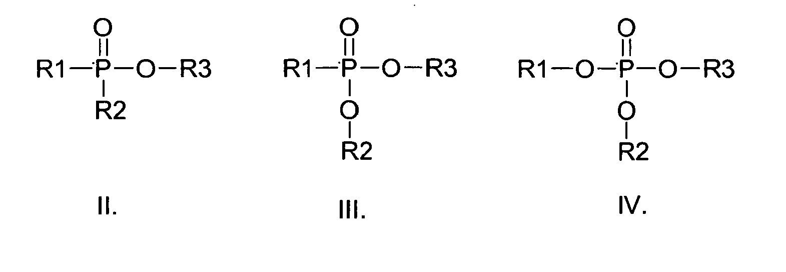 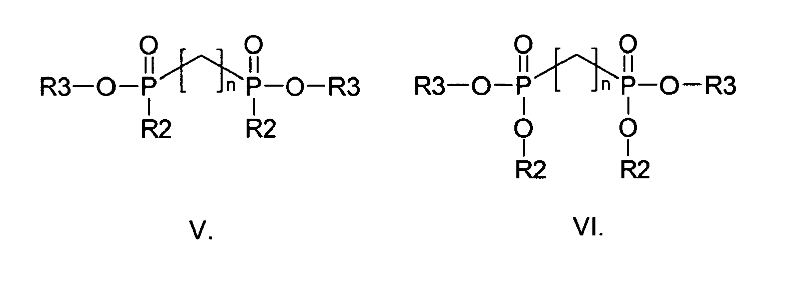 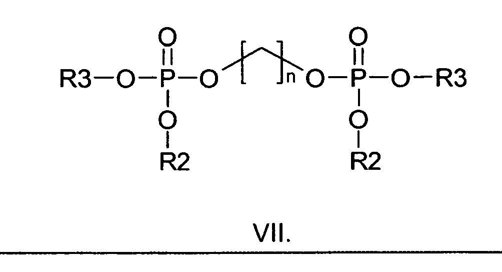 wherein R1, R2 and R3 can be equal or different and are selected independently from the group consisting of H or the counter ions NH₄⁺, Li⁺, Na⁺, K⁺, C₁-C₂₀ alkyl, substituted or unsubstituted, linear or branched, C₁-C₆ alkaryl, linear or branched, substituted or unsubstituted and aryl, substituted or unsubstituted and wherein n is an integral number ranging from 1 to 15.

2. An aqueous post-treatment composition according to claim 1, wherein n for compounds according to formula I ranges from 2 to 100.

3. An aqueous post-treatment composition according to any of the foregoing claims, wherein m ranges from 1 to 25.

4. An aqueous post-treatment composition according to any of the foregoing claims, wherein n for compounds according to formula I ranges from 5 to 50.

5. An aqueous post-treatment composition according to any of the foregoing claims, wherein m ranges from 2 to 10.

6. An aqueous post-treatment composition according to any of the foregoing claims, wherein the at least one polysiloxane betaine compound represented by formula I is used in an amount of 0.05 to 50 g/l.

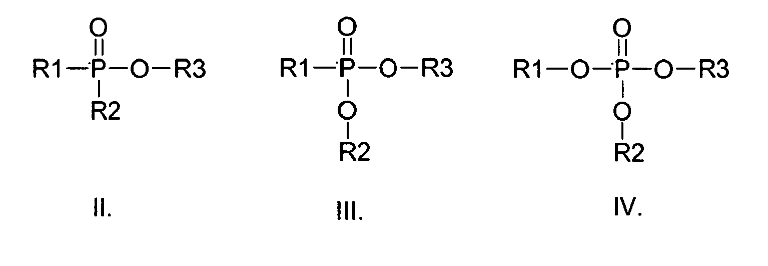

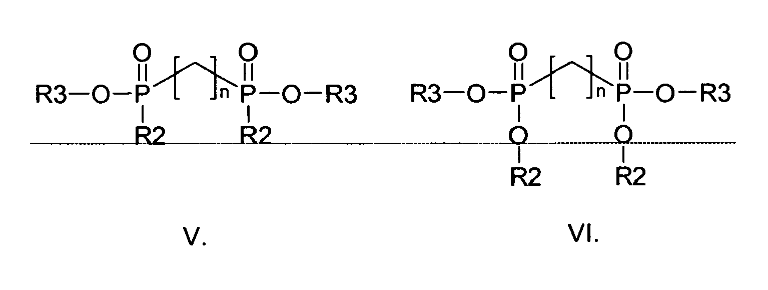

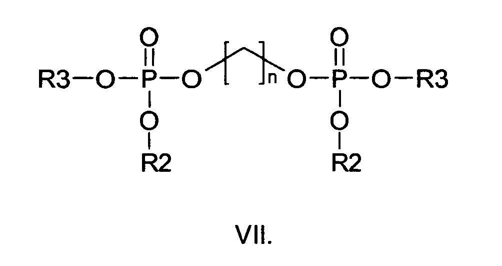

7. An aqueous post-treatment composition according to any of the foregoing claims, wherein the at least one phosphorous compound represented by the formulas II. - VII. is used in an amount of 0.02 to 10 g/l.

8. A process for increasing corrosion resistance of a substrate having a metal or metal alloy surface by contacting the surface with an aqueous post-treatment composition according to any of the foregoing claims.

9. A substrate having a metal or metal alloy surface treated with the aqueous post-treatment composition according to any of the claims 1-7.

10. A substrate according to claim 9 having at least one layer selected from the group comprising gold, gold alloy, nickel, nickel phosphorus alloy, nickel boron alloy, nickel palladium alloy, ternary nickel alloy, palladium, tin, tin alloy, copper, copper alloy, tin, tin alloy, silver, silver alloy chromium and chromium alloy.

11. A substrate according to claims 9 and 10, wherein the substrate is a gold or gold alloy plated semi-finished good like a gold or gold alloy plate or gold or gold alloy wire or a lead frame, a connector or a printed circuit board.

## Patentansprüche

1. Eine wässrige Zusammensetzung für die Nachbehandlung einer Metall- oder Metalllegierungsoberfläche bestehend aus
mindestens einer Polyorganosiloxan-Betain-Verbindung repräsentiert durch Formel I: 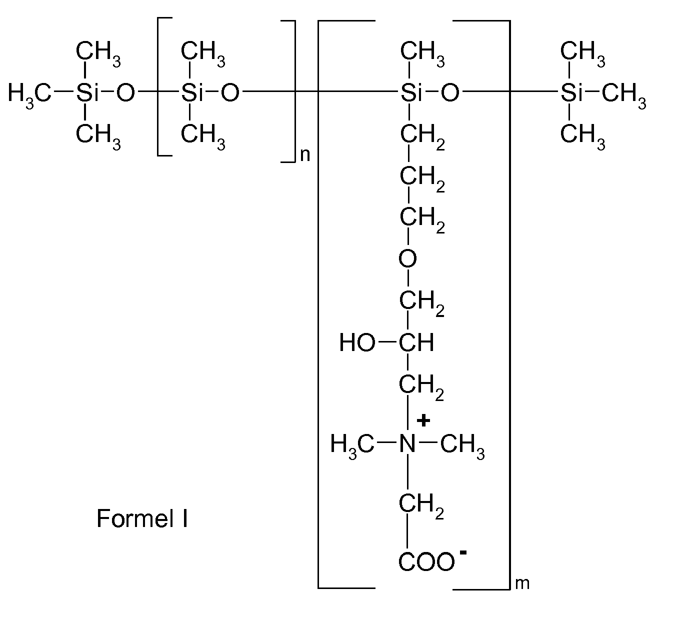 wobei n für Verbindungen gemäß Formel I von 0 bis 200 reicht und m von 1 bis 50 reicht und mindestens eine Phosphorverbindung oder deren Salz repräsentiert wird durch die Formeln II. bis VII.: 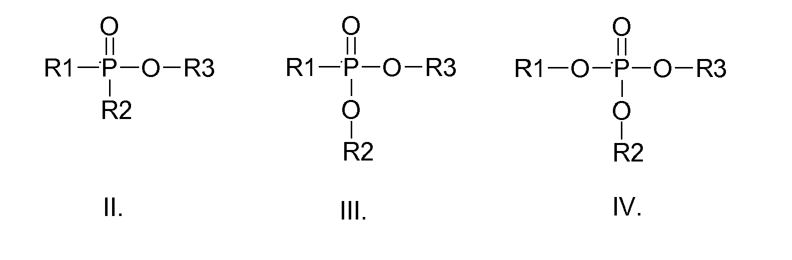 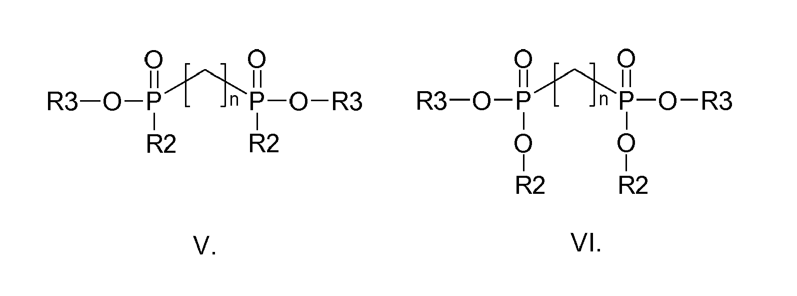 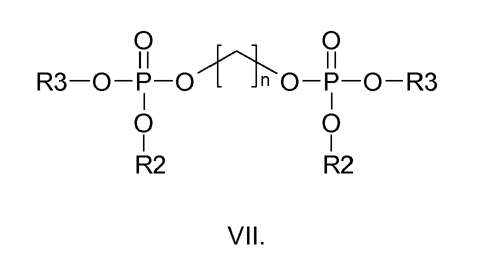 wobei R1, R2 und R3 gleich oder unterschiedlich sein können und unabhängig gewählt werden von der Gruppe bestehend aus H oder den Gegenionen NH₄⁺, Li⁺, Na⁺, K⁺, C₁-C₂₀ Alkyl, substitutiert oder unsubstituiert, linear oder verzweigt, C₁-C₆ Alkaryl, linear oder verzweigt, substitutiert oder unsubstituiert und Aryl, substituiert oder unsubstituiert und wobei n eine ganze Zahl zwischen 1 und 15 ist.

2. Eine wässrige Zusammensetzung für die Nachbehandlung nach Anspruch 1, **dadurch gekennzeichnet, dass** n für Verbindungen gemäß Formel I von 2 bis 100 reicht.

3. Eine wässrige Zusammensetzung für die Nachbehandlung nach einem der vorstehenden Ansprüche, **dadurch gekennzeichnet, dass** m von 1 bis 25 reicht.

4. Eine wässrige Zusammensetzung für die Nachbehandlung nach einem der vorstehenden Ansprüche, **dadurch gekennzeichnet, dass** n für Verbindungen gemäß Formel I von 5 bis 50 reicht.

5. Eine wässrige Zusammensetzung für die Nachbehandlung nach einem der vorstehenden Ansprüche, **dadurch gekennzeichnet, dass** m von 2 bis 10 reicht.

6. Eine wässrige Zusammensetzung für die Nachbehandlung nach einem der vorstehenden Ansprüche, **dadurch gekennzeichnet, dass** mindestens eine Polyorganosiloxan-Betain-Verbindung repräsentiert durch Formel I in einer Menge von 0,05 bis 50 g/l verwendet wird.

7. Eine wässrige Zusammensetzung für die Nachbehandlung nach einem der vorstehenden Ansprüche, **dadurch gekennzeichnet, dass** mindestens eine Phosphorverbindung repräsentiert durch die Formeln II. - VII. in einer Menge von 0,02 bis 10 g/l verwendet werden.

8. Ein Verfahren für die Erhöhung der Korrosionsbeständigkeit eines Substrats mit einer Metall- oder Metallegierungsoberfläche durch In-Kontakt-Bringen der Oberfläche mit einer wässrigen Zusammensetzung für die Nachbehandlung nach einem der vorstehenden Ansprüche.

9. Ein Substrat mit einer Oberfläche aus Metall oder Metallegierung behandelt mit der wässrigen Zusammensetzung für die Nachbehandlung nach einem der Ansprüche 1-7.

10. Ein Substrat nach Anspruch 9 mit mindestens einer Schicht gewählt aus der Gruppe, die Gold, Goldlegierung, Nickel, Nickel-Phosphor-Legierung, Nickel-Bor-Legierung, Nickel-Palladium-Legierung, ternäre Nickellegierung, Palladium, Zinn, Zinnlegierung, Kupfer, Kupferlegierung, Zinn, Zinnlegierung, Silber, Silberlegierung, Chrom und Chromlegierung umfasst.

11. Ein Substrat nach den Ansprüchen 9 und 10, **dadurch gekennzeichnet, dass** das Substrat ein mit Gold oder Goldlegierung plattiertes Halbfertigfabrikat ist wie eine Gold- oder Goldlegierungsplatte oder Gold- oder Goldlegierungsdraht oder ein Leiterrahmen, ein Verbinder oder eine Platine.

## Revendications

1. Une composition aqueuse pour le traitement ultérieur d'une surface métallique ou en alliage métallique comprenant
au moins un composé bétaïne polysiloxane de formule 1 : 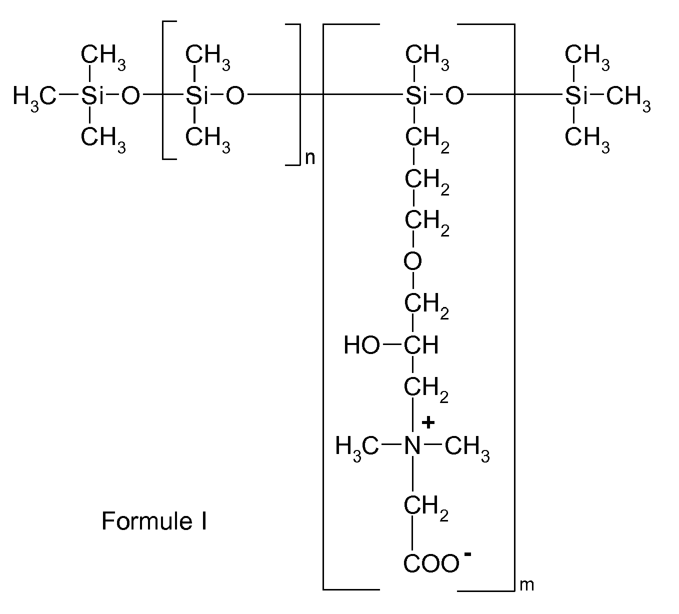 où n varie entre 0 et 200 pour les composés selon la formule I et m entre 1 et 50, et au moins un composé phosphore ou leurs sels répondant aux formules II. à VII. : 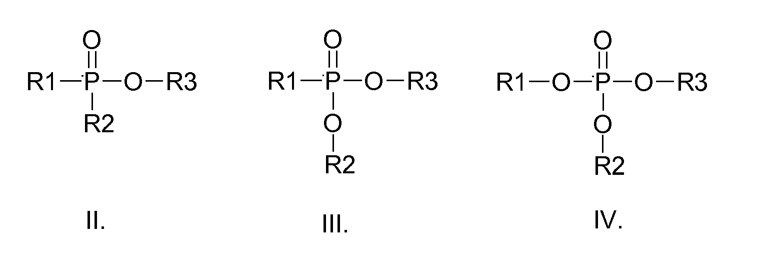 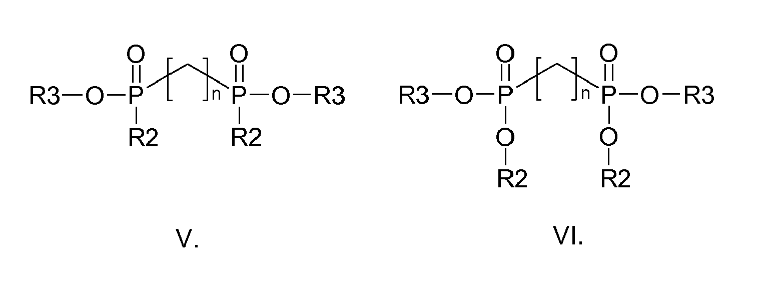 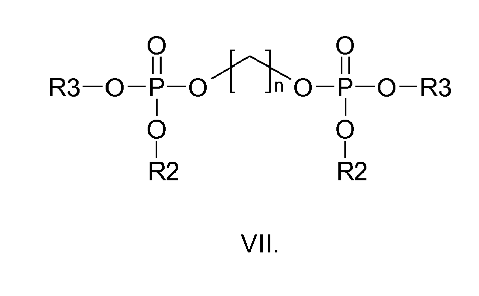 R1, R2 et R3 pouvant être identiques ou non et choisis indépendamment d'un groupe composé de H, des contre-ions NH₄⁺, Li⁺, Na⁺, K⁺, des substituants C₁-C₂₀ alkyle, substitué ou non-substitué, linéaire ou ramifié, C₁-C₆ alkaryle, linéaire ou ramifié, substitué ou non-substitué et aryle, substitué ou non-substitué et où n est un nombre entier compris entre 1 et 15.

2. Une composition aqueuse pour le traitement ultérieur selon la revendication 1, **caractérisée en ce que** n varie entre 2 et 100 pour les composés selon la formule I.

3. Une composition aqueuse pour le traitement ultérieur selon l'une des revendications précédentes, **caractérisée en ce que** m varie entre 1 et 25.

4. Une composition aqueuse pour le traitement ultérieur selon l'une des revendications précédentes, **caractérisée en ce que** n varie entre 5 et 50 pour les composés selon la formule I.

5. Une composition aqueuse pour le traitement ultérieur selon l'une des revendications précédentes, **caractérisée en ce que** m varie entre 2 et 10.

6. Une composition aqueuse pour le traitement ultérieur selon l'une des revendications précédentes, **caractérisée en ce que** l'on utilise au moins un composé bétaïne polysiloxane de formule I, dans une quantité comprise entre 0,05 et 50 g/l.

7. Une composition aqueuse pour le traitement ultérieur selon l'une des revendications précédentes, **caractérisée en ce que** l'on utilise au moins un composé phosphore de formules II. à VII., dans une quantité comprise entre 0,02 bis 10 g/l.

8. Un procédé visant à améliorer la résistance à la corrosion d'un substrat avec une surface métallique ou en alliage métallique en mettant en contact ladite surface avec une composition aqueuse pour le traitement ultérieur selon l'une des revendications précédentes.

9. Un substrat avec une surface métallique ou en alliage métallique traité avec une composition aqueuse pour le traitement ultérieur selon l'une des revendications 1 à 7.

10. Un substrat selon la revendication 9 avec au moins une couche choisie parmi le groupe contenant or, alliage d'or, nickel, alliage de nickel-phosphore, alliage de nickel-bore, alliage de nickel-palladium, alliage ternaire au nickel, palladium, étain, alliage d'étain, cuivre, alliage de cuivre, étain, alliage d'étain, argent, alliage d'argent, chrome et alliage de chrome.

11. Un substrat selon les revendications 9 et 10, dans lequel le substrat est un produit semi-fini plaqué or ou alliage or ainsi qu'une plaque en or ou en alliage d'or ou un fil en or ou en alliage d'or ou un cadre de montage, un connecteur ou un circuit imprimé.
